# EUROPÄISCHE PATENTSCHRIFT

(11) **EP 3 589 989 B1**
(45) Veröffentlichungstag und Bekanntmachung des Hinweises auf die Patenterteilung: **11.10.2023**
(21) Anmeldenummer: 18710785.9
(22) Anmeldetag: 27.02.2018
(51) Int. Cl.: G02B 1/12, G02B 5/08, G03F 7/20

(54) **VERFAHREN ZUR KORREKTUR EINES REFLEKTIVEN OPTISCHEN ELEMENTS FÜR DEN WELLENLÄNGENBEREICH VON 5 NM BIS 20 NM**
METHOD FOR CORRECTING A REFLECTIVE OPTICAL ELEMENT FOR THE WAVELENGTH RANGE BETWEEN 5 NM AND 20 NM.
PROCÉDÉ DE CORRECTION D'UN ÉLÉMENT OPTIQUE RÉFLÉCHISSANT POUR LA GAMME DE LONGUEURS D'ONDE ALLANT DE 5 NM A 20 NM

(30) Priorität: 28.02.2017 DE 102017203246
(43) Veröffentlichungstag der Anmeldung: 08.01.2020
(73) Patentinhaber: Carl Zeiss SMT GmbH, 73447 Oberkochen (DE)
(72) Erfinder: KALDEN, Joachim, 73457 Essingen (DE)
(74) Vertreter: Werner & ten Brink
(86) Internationale Anmeldenummer: PCT/EP2018/054769
(87) Internationale Veröffentlichungsnummer: WO 2018/158229

(56) Entgegenhaltungen:
- DE-A1-102008 041 144
- DE-A1-102009 055 119
- DE-A1-102011 084 117
- DE-A1-102014 225 197
- DE-A1-102016 217 694
- DE-B4-102009 055 119
- US-A1- 2003 081 722

## Beschreibung

Die vorliegende Erfindung bezieht sich auf ein Verfahren zur Korrektur eines reflektiven optischen Elements für den Wellenlängenbereich von 5 nm bis 20 nm, das auf einem Substrat ein Viellagensystem aufweist, wobei das Viellagensystem Lagen aus mindestens zwei verschiedenen Materialien mit unterschiedlichem Realteil des Brechungsindex bei einer Wellenlänge im extrem ultravioletten Wellenlängenbereich aufweist, die abwechselnd angeordnet sind. Außerdem bezieht sich die vorliegende Erfindung auf ein reflektives optisches Element für den Wellenlängenbereich von 5 nm bis 20 nm, das auf einem Substrat ein Viellagensystem aufweist, wobei das Viellagensystem Lagen aus mindestens zwei verschiedenen Materialien mit unterschiedlichem Realteil des Brechungsindex bei einer Wellenlänge im extrem ultravioletten Wellenlängenbereich aufweist, die abwechselnd angeordnet sind. Ferner bezieht sich die Erfindung auf ein optisches System sowie eine EUV-Lithographievorrichtung. Die vorliegende Anmeldung nimmt die Priorität der deutschen Patentanmeldung 10 2017 203 246.4 vom 28. Februar 2017 in Anspruch.

In EUV-Lithographievorrichtungen werden zur Lithographie von Halbleiterbauelementen reflektive optische Elemente für den extrem ultravioletten (EUV-)Wellenlängenbereich (z.B. Wellenlängen zwischen ca. 5 nm und 20 nm) wie etwa Masken oder Spiegel auf der Basis von Viellagensystemen eingesetzt. Da EUV-Lithographievorrichtungen in der Regel mehrere reflektive optische Elemente aufweisen, müssen diese eine möglichst hohe Reflektivität aufweisen, um eine hinreichend hohe Gesamtreflektivität sicherzustellen.

Die Verteilung der Reflektivität über die Fläche eines Viellagensystems eines reflektiven optischen Elements kann die Abbildungseigenschaften eines optischen Systems mit einem solchen reflektiven optischen Element beeinflussen, beispielsweise die Apodisation und die Wellenfront. Oft ist eine besonders hohe Homogenität der reflektierten Strahlung von Interesse. Ggf. kann es notwendig sein, einen oder mehrere EUV-Spiegel bzw. die Maske zu korrigieren, um etwa eine erhöhte Homogenität der vom optischen System zur Verfügung gestellten Strahlung zu erreichen. Vergleichbare optische Systeme werden außer in der EUV-Lithographie beispielsweise auch in Geräten zu Masken- oder Waferinspektion eingesetzt.

In der DE 10 2011 084 117 A1 wird ein EUV-Spiegelsubstrat zwecks Kompaktierung des Substratmaterials mit Elektronen bestrahlt. Dies kann vor der Beschichtung des Substrats und/oder nach Aufbringen einer Schutzschicht und/oder an einem fertigen Spiegel geschehen. Vor dem Kompaktieren wird die Oberflächenform des Substrats oder des mit Schutzschicht versehenen Substrats oder des Spiegels interferometrisch vermessen.

Auch gemäß der DE 10 2014 225 197 A1 wird die das Substrat eines EUV-Spiegels mit Elektronen oder Photonen bestrahlt, um es zu kompaktieren und zwar wird eine andere Seite des Substrats als die mit der durch Kompaktierung zu ändernde Oberflächenform, bevorzugt die entgegengesetzte Seite bestrahlt. Vorbereitend kann die Wellenfrontaberration des Spiegels bzw. eines Projektionsobjektivs, in das der Spiegel eingebaut ist, nämlich durch interferometrische Vermessung der Oberflächenform bestimmt werden.

Die DE 10 2016 217 694 A1 befasst sich mit Spiegeln für die EUV-Lithographie mit einem Reflexionsschichtsystem auf einem Substrat und einer Absorptionsschicht. Diese kann unter oder auf dem Reflexionsschichtsystem angeordnet sein und kann als Antireflexionsschicht ausgebildet sein oder ohne weitere Erläuterungen durch lokale Kompaktierung, Durchmischung oderAufrauung mittels lokales lonenstrahlbearbeitung. In letzterem Fall dient sie als Positionier- bzw. Justageelement. In den übrigen Fällen zur Eliminierung unerwünschter Beugungsordnungen.

In der DE 10 2008 041 144 A1 geht es um eine optische Anordnung mit transmissivem optischen Element mit Beschichtung, die Korrekturstrukturen aufweisen können. Die Korrekturstrukturen werden iterativ mithilfe von anstelle des zu korrigierenden Linsenelements in den Strahlengang eingebrachten Referenzelementen bestimmt und können beispielsweise durch lokalen Abtrag von Schichten durch lonenstrahlbearbeitung, nämlich Ion Beam Figuring (IBF), eingebracht werden.

Aus der US 2002/0122989 A1 ist im Zusammenhang mit der Herstellung von Masken für die EUV-Lithographie bekannt, die Reflektivität eines Viellagensystems auf einer Maske durch Bestrahlung mit insbesondere fokussierten Elektronenstrahlen lokal zu vermindern. Insbesondere wird bei Viellagensystemen auf der Basis von Molybdän und Silizium durch den Elektronenstrahl Energie in das Viellagensystem eingetragen, die zu einer Kontraktion der Lagendicken führt, die proportional zur Energiedosis ist und auf der Bildung von Molybdänsilizid beruht.

Es ist eine Aufgabe der vorliegenden Erfindung, einen Weg zur Korrektur von EUV-Spiegeln vorzuschlagen.

Diese Aufgabe wird gelöst durch ein Verfahren zur Korrektureines reflektiven optischen Elements für den Wellenlängenbereich von 5 nm bis 20 nm, das auf einem Substrat ein Viellagensystem aufweist, wobei das Viellagensystem Lagen aus mindestens zwei verschiedenen Materialien mit unterschiedlichem Realteil des Brechungsindex bei einer Wellenlänge im extrem ultravioletten Wellenlängenbereich aufweist, die abwechselnd angeordnet sind, und wobei das reflektive optische Element eine oder mehrere Teilflächen aufweist, die eine gemessene Reflektivität aufweist bzw. aufweisen, die über einer Sollreflektivität einer Sollverteilung der Reflektivität über die Fläche des Viellagensstems liegt, dadurch gekennzeichnet, dass das Viellagensystem an dieser oder diesen Teilfläche(n) mit Elektronen bestrahlt wird, so daß lokal die Struktur des Viellagensystems verändert und die Reflektivität geringer wird.

Die Reflektivität eines für EUV-Strahlung ausgelegten Viellagensystems wird durch eine alternierende Abfolge der Materialien gewährleistet, die sehr empfindlich von den jeweiligen Schichtdicken und den Grenzflächen zwischen den Schichten abhängt. Durch das Bestrahlen des Viellagensystems kann lokal die Struktur so verändert werden, dass die präzise Periodizität verloren geht und damit die Reflektivität an dieser Stelle geringer wird.

Ein Vorteil der vorgeschlagenen Vorgehensweise besteht darin, dass ein bereits in einem optischen System befindlicher Spiegel oder Maske überprüft und ggf. lokal bestrahlt werden kann. Je nach Auslegung des optischen Systems kann die Bestrahlung auch in situ, eventuell sogar während dessen Betriebs stattfinden. Das vorgeschlagene Vorgehen kann ebenso in Geräten zur Inspektion von Masken und Maskenrohlingen eingesetzt werden. Auch Spiegel können außerhalb eines optischen Systems wie vorgeschlagen korrigiert werden.

Schwankungen der reflektierten Intensität über die Fläche können u.a. auf Schwankungen der auftreffenden Strahlung beruhen. Dem kann begegnet werden, indem in eine Sollverteilung der Reflektivität ermittelt wird, in der die Intensitätsschwankungen der auftreffenden Strahlung zumindest teilweise kompensiert werden. Kann von einer hinreichend homogenen auftreffenden Strahlungsintensität ausgegangen werden bzw. soll verhindert werden, das durch Reflexion an einem EUV-Spiegel oder einem anderen reflektiven optischen Element die bestehende Intensitätsverteilung über die Fläche zu sehr verändert wird, kann von einer relativ konstanten Sollverteilung ausgegangen werden, vorteilhafterweise von einer, die um nicht mehr als 1%, bevorzugt nicht mehr als 0,5%, besonders bevorzugt nicht mehr als um 0,1% um einen Mittelwert schwankt. Entsprechend kann eine Sollverteilung zum Kompensieren von Schwankungen der auftreffenden Strahlung so gewählt werden, dass die Intensitätsverteilung über die Fläche der reflektierten Strahlung um nicht mehr als 1%, bevorzugt nicht mehr als 0,5%, besonders bevorzugt nicht mehr als um 0,1% um einen Mittelwert schwankt. Je nach beabsichtigter Anwendung können beliebige Sollverteilungen gewählt werden. Mittels der vorgeschlagenen Vorgehensweise kann lokal die tatsächliche Reflektivität reduziert werden, um sich der Sollreflektivität an dieser Stelle anzunähern.

Vorteilhafterweise ist beim Bestrahlen die Energie der Elektronen derart gewählt, dass sie unter der Sputtergrenze oder der Kompaktierungsgrenze, bevorzugt sowohl unter der Sputter- als auch der Kompaktierungsgrenze liegt. Ein Abtragen von Material des Viellagensystems könnte zu unerwünschten Änderungen von optischen Eigenschaften des reflektiven optischen Elements führen wie auch zu unkontrollierter Reduzierung der Reflektivität an der bestrahlten Stelle. Das gesputterte Material könnte auch zu unerwünschter Kontamination benachbarter Teilflächen auf der Oberfläche des reflektiven optischen Elements führen. Eine Kompaktierung könnte die optischen Eigenschaften des reflektiven optischen Elements verändern.

Vorteilhafterweise wird mit einem gepulsten Elektronenstrahl bestrahlt. Dadurch kann die eingetragene Energiedosis besser kontrolliert werden. Insbesondere kann dadurch einfacher gewährleistet werden, dass der Energieeintrag ausreicht, um die Struktur im Viellagensystem auf atomarer Ebene zu verändern, insbesondere die Schärfe der Grenzflächen zwischen den einzelnen Lagen, aber keine chemischen Reaktionen gefördert werden, die zu einer Kontraktion oder Expansion des Viellagensystems führen würden und dadurch die optischen Eigenschaften des Spiegels verändern könnten.

Das korigierte reflektive optische Element kann als Spiegel, Maskenrohling oder Maske ausgebildet sein. Ein reflektives optisches Element mit dem Aufbau eines Spiegels kann als Maskenrohling dienen. Etwa durch Aufbringen einer absorbierenden Schicht kann die reflektierende Oberfläche des Maskenrohlings strukturiert werden, um so eine Maske zu erhalten. Ein häufig verwendeter Parameter zum Beschreiben der Maskenstruktur ist beispielsweise die geometrische Breite einer Linie, der als kritische Dimension oder CD (für "critical dimension") bezeichnet wird.

Optische Systeme mit einem reflektiven optischen Element, diekorrigiert wurden wie weiter oben erläutert können beispielsweise in EUV-Lithographievorrichtungen oder auch in Inspektionssystemen für Wafer oder Masken eingesetzt werden.

Außerdem wird die Aufgabe gelöst durch eine EUV-Lithographievorrichtung mit einem optischen System mit einem reflektiven optischen Element, das wie weiter oben erläutert korrigiert wurde und einer EUV-Strahlungsquelle, wobei die Strahlung der EUV-Strahlungsquelle mit einer über die Fläche des Viellagensystems des reflektiven optischen Elements variierenden Intensität auf den Spiegel trifft und wobei die eine oder mehreren mit Elektronen bestrahlten Teilflächen in Flächenbereichen höherer Intensität liegen.

Es hat sich herausgestellt, dass die Gleichmäßigkeit der Ausleuchtung des für den Lithographieprozess genutzten Strahlungsfeldes typischerweise dadurch begrenzt wird, dass die optischen Systeme einer EUV-Lithographievorrichtung am Rand des Strahlungsfeldes eine geringere Transmission aufweist als in der Feldmitte. Daher ist es besonders vorteilhaft, einen oder mehrere reflektive optische Elemente bereitzustellen, die in Bereichen hoher auftreffender Intensität, wie etwa in der Feldmitte, eine etwas reduzierte Reflektivität aufweisen bzw. dahingehend korrigiert wurden.

Bevorzugt weisen die eine oder mehreren Teilflächen, die in Flächenbereichen höherer Intensität liegen, eine quadratische Rauheit von über 0,25 nm auf. Die quadratische Rauheit, die auch RMS(root mean squared roughness)-Rauheit genannt wird, wird aus dem Mittel der Quadrate der Abweichung der Messpunkte über die Oberfläche zu einer mittleren Fläche berechnet, die so durch die Oberfläche gelegt wird, das die Summe der Abweichungen bezogen auf die mittlere Fläche minimal ist. Insbesondere für optische Elemente für die EUV-Lithographie ist die Rauheit in einem Ortsfrequenzbereich von 0,1 µm bis 200 µm von besonderer Bedeutung, da Rauheit in diesem Bereich zu verstärkter Streustrahlung führt, was die Reflektivität reduziert.

Die vorliegende Erfindung soll unter Bezugnahme auf ein bevorzugtes Ausführungsbeispiel näher erläutert werden. Dazu zeigen
- Figur 1: schematisch eine EUV-Lithographievorrichtung;
- Figur 2: eine schematische Aufsicht auf einen beleuchteten EUV-Spiegel;
- Figur 3: schematisch den Aufbau eines EUV-Spiegels mit Viellagensystem;
- Figur 4: schematisch den Aufbau einer Maske mit Viellagensystem
- Figur 5: schematisch die Struktur eines Viellagensystems;
- Figur 6: schematisch die Struktur des Viellagensystems aus Figur 5 nach Eindringen eines Ions; und
- Figur 7: schematisch den Ablauf einer beispielhaften Ausführung des vorgeschlagenen Korrekturverfahrens.

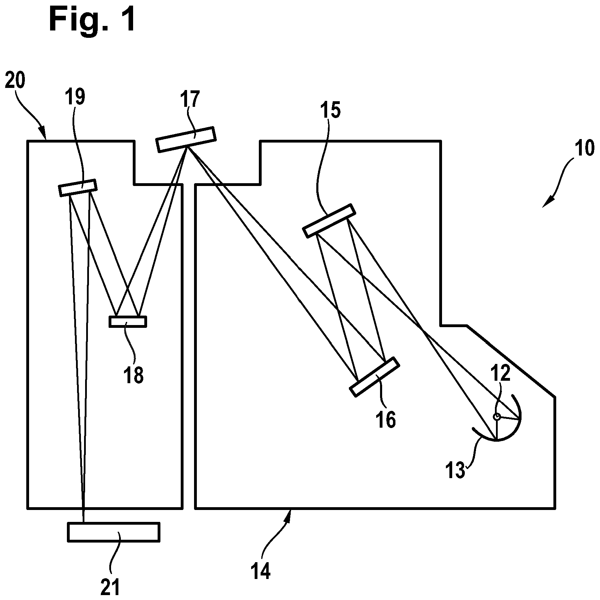

In Figur 1 ist schematisch eine EUV-Lithographievorrichtung 10 beispielhaft dargestellt. Wesentliche Komponenten sind das Beleuchtungssystem 14, die Maske 17 und das Projektionssystem 20. Die EUV-Lithographievorrichtung 10 wird unter Vakuumbedingungen betrieben, damit die EUV-Strahlung in ihrem Inneren möglichst wenig absorbiert wird.

Als Strahlungsquelle 12 kann beispielsweise eine Plasmaquelle oder auch ein Synchrotron dienen. Im hier dargestellten Beispiel handelt es sich um eine laserbetriebene Plasmaquelle. Die emittierte Strahlung im Wellenlängenbereich von etwa 5 nm bis 20 nm wird zunächst vom Kollektorspiegel 13 gebündelt. Der Betriebsstrahl 11 wird dann auf die im Strahlengang folgenden reflektiven optischen Elemente im Beleuchtungssystem 14 eingeführt. Im in Figur 1 dargestellten Beispiel weist das Beleuchtungssystem 14 zwei weitere Spiegel 15, 16 auf. Die Spiegel 15, 16 leiten den Strahl auf die Maske 17, die die Struktur aufweist, die auf den Wafer 21 abgebildet werden soll. Bei der Maske 17 handelt es sich ebenfalls um ein reflektives optisches Element für den EUV- Wellenlängenbereich, das je nach Lithographieprozess ausgewechselt werden kann. Mit Hilfe des Projektionssystems 20 wird der von der Maske 17 reflektierte Strahl auf den Wafer 21 projiziert und dadurch die Struktur der Maske auf ihn abgebildet. Das Projektionssystem 20 weist im dargestellten Beispiel zwei Spiegel 18, 19 auf. Es sei darauf hingewiesen, dass sowohl das Projektionssystem 20 als auch das Beleuchtungssystem 14 jeweils nur einen oder auch drei, vier, fünf und mehr Spiegel aufweisen können.

Jeder der hier dargestellten Spiegel 13, 15, 16, 18, 19 sowie die Maske 17 kann auf einem Substrat ein Viellagensystem aufweisen, wobei das Viellagensystem Lagen aus mindestens zwei verschiedenen Materialien mit unterschiedlichem Realteil des Brechungsindex bei einer Wellenlänge im extrem ultravioletten Wellenlängenbereich aufweist, die abwechselnd angeordnet sind, und kann mit folgenden Schritten korrigiert werden:
- Vermessen der Reflektivitätsverteilung über die Fläche des Viellagensystems;
- Vergleichen der gemessenen Reflektivitätsverteilung mit einer Sollverteilung der Reflektivität über die Fläche des Viellagensystems und Bestimmen von einer oder mehreren Teilflächen, die eine gemessene Reflektivität aufweisen, die über der Sollreflektivität liegt; und
- Bestrahlen der einen oder mehreren Teilflächen mit Ionen oder Elektronen.

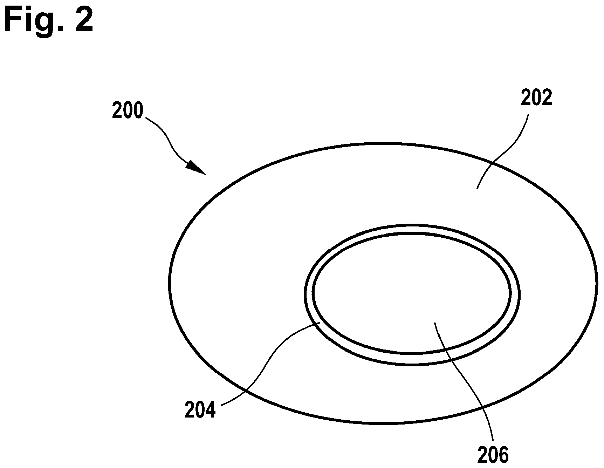

Besonders vorteilhaft ist es, wenn ein Spiegel 200 eines optischen Systems einer EUV-Lithographievorrichtung korrigiert wird, auf den die Strahlung der EUV-Strahlungsquelle mit einer über die Fläche 202 des Viellagensystems des Spiegels 200 variierenden Intensität auf den Spiegel 200 trifft. In Figur 2 ist ein Gebiet 204 der Fläche 202 des Viellagensystems eingezeichnet, auf das die einfallende Strahlung mit einer Intensität über einem Schwellenwert, etwa dem Mittelwert auftrifft. Um in diesem Gebiet 204 die Reflektivität des Spiegels 200 zu reduzieren, wurde die Teilfläche 206 mit Elektronen oder bevorzugt Ionen bestrahlt. Durch diese Bestrahlung wurde die Periodizität des Viellagensystems gestört, wodurch die Reflektivität im Bereich der Teilfläche reduziert wurde. Insbesondere wurden die Grenzflächen zwischen den einzelnen Lagen bzw. die Oberfläche des Viellagensystems auf eine RMS-Rauigkeit von über 0,25 nm aufgeraut, was zu stärkerer Streustrahlung und entsprechend reduzierter Reflektivität führt. Es sei darauf hingewiesen, dass im hier dargestellten Beispiel das Gebiet 204 erhöhter Intensität die bestrahlte Teilfläche 206 vollständig umfasst und etwas größer ist. In weiteren Ausführungen kann es auch umgekehrt sein oder das Gebiet 204 und die Teilfläche 206 identisch sein oder beide nur teilweise überlappen. Das in Verbindung mit Spiegel 200 Erläuterte gilt ebenso für Masken und Maskenrohlinge.

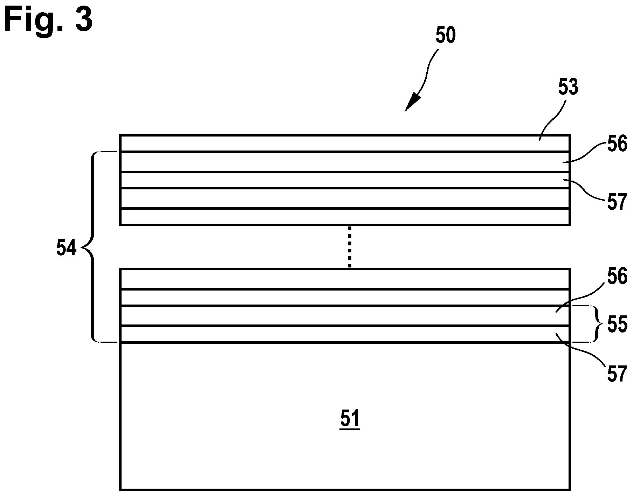

In Figur 3 ist schematisch der Aufbau eines EUV-Spiegels 50 dargestellt, dessen reflektive Beschichtung auf einem Viellagensystem 54 basiert. Dabei handelt es sich um auf eine Substrat 51 alternierend aufgebrachte Lagen eines Materials mit höherem Realteil des Brechungsindex bei der Arbeitswellenlänge, bei der beispielsweise die lithographische Belichtung durchgeführt wird, (auch Spacer 56 genannt) und eines Materials mit niedrigerem Realteil des Brechungsindex bei der Arbeitswellenlänge (auch Absorber 57 genannt), wobei ein Absorber-Spacer-Paar einen Stapel 55 bildet. Dadurch wird in gewisser Weise ein Kristall simuliert, dessen Netzebenen den Absorberlagen entsprechen, an denen Bragg-Reflexion stattfindet. Üblicherweise werden reflektive optische Elemente für eine EUV-Lithographievorrichtung oder ein optisches System derart ausgelegt, dass die jeweilige Wellenlänge maximaler Reflektivität mit der Arbeitswellenlänge des Lithographieprozesses oder sonstigen Anwendungen des optischen Systems im Wesentlichen übereinstimmt.

Die Dicken der einzelnen Lagen 56, 57 wie auch der sich wiederholenden Stapel 55 können über das gesamte Viellagensystem 54 konstant sein oder auch über die Fläche oder die Gesamtdicke des Viellagensystems 54 variieren, je nach dem, welches spektrale oder winkelabhängige Reflexionsprofil bzw. welche maximale Reflektivität bei der Arbeitswellenlänge erreicht werden soll. Das Reflexionsprofil kann auch gezielt beeinflusst werden, indem die Grundstruktur aus Absorber 57 und Spacer 56 um weitere mehr und weniger absorbierende Materialien zu ergänzt wird, um die mögliche maximale Reflektivität bei der jeweiligen Arbeitswellenlänge zu erhöhen. Dazu können in manchen Stapeln Absorber und/oder Spacer-Materialien gegeneinander ausgetauscht werden oder die Stapel aus mehr als einem Absorber- und/oder Spacermaterial aufgebaut werden. Ferner können auch zusätzliche Lagen als Diffusionsbarrieren zwischen Spacer- und Absorberlagen 56, 57 vorgesehen werden. Eine beispielsweise für eine Arbeitswellenlänge von 13,4 nm übliche Materialkombination ist Molybdän als Absorber- und Silizium als Spacermaterial. Dabei hat ein Stapel 55 oft eine Dicke von ca. 6,7 nm, wobei die Spacerlage 56 meist dicker ist als die Absorberlage 57. Weitere übliche Materialkombinationen sind u.a. Silizium-Ruthenium oder Molybdän-Beryllium. Außerdem kann auf dem Viellagensystem 54 eine Schutzschicht 43 vorgesehen sein, die auch mehrlagig ausgelegt sein kann.

Typische Substratmaterialien für reflektive optische Elemente für die EUV-Lithographie, insbesondere Kollektorspiegel, sind Silizium, Siliziumkarbid, siliziuminfiltriertes Siliziumkarbid, Quarzglas, titandotiertes Quarzglas, Glas und Glaskeramik. Ferner kann das Substrat auch aus Kupfer, Aluminium, einer Kupferlegierung, einer Aluminiumlegierung oder einer Kupfer-Aluminium-Legierung sein. Besonders bevorzugt für Spiegel, Masken und Maskenrohlinge sind Substratmaterialien mit einem niedrigen Wärmeausdehnungskoeffizienten.

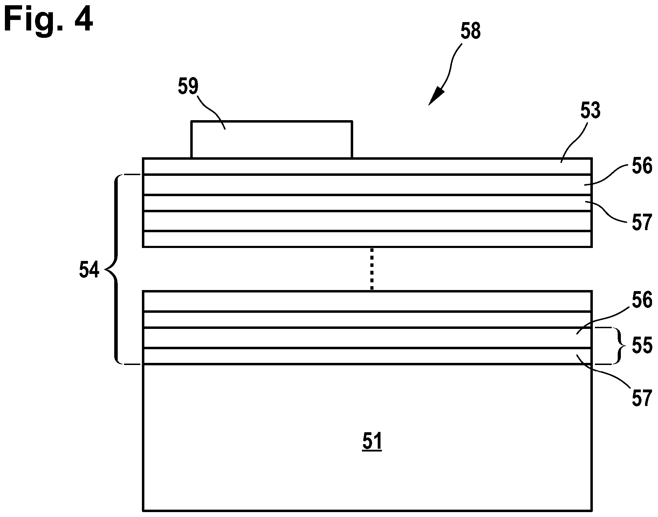

Ein Spiegel mit dem soeben beschriebenen Aufbau kann auch als Maskenrohling zur Herstellung einer Maske verwendet werden. Eine entsprechende Maske 59 ist schematisch in Figur 4 dargestellt. Die Maske 59 unterscheidet sich von dem Spiegel 50 aus Figur 3 darin, dass auf der fakultativen Schutzlage 53 des Viellagensystems 54 eine absorbierende Schicht 58 vorgesehen ist. Die absorbierende Schicht 58 absorbiert die auftreffende EUV-Strahlung zu einem großen Teil, so dass in diesem Flächenbereich deutlich weniger EUV-Strahlung reflektiert wird und auf einem Wafer im entsprechenden Flächenbereich vorhandener Photoresist nicht belichtet wird. Geeignete Materialien für die absorbierende Schicht 58 können beispielsweise u.a. Aluminium, Aliminium-Kupfer-Legierung, Chrom, Tantal, Titan, Wolfram, Nickelsilizid, Tantalborid, Tantalnitrid, Tantalsilizid, Tantalsiliziumnitrid, Titannitrid sein. Es ist auch möglich, eine mehrlagige absorbierende Schicht vorzusehen. Man kann einen Maskenrohling vor Aufbringen einer absorbierenden Schicht wie vorgeschlagen korrigieren oder bei einer Maske die nicht mit absorbierender Schicht versehenen Teilflächen.

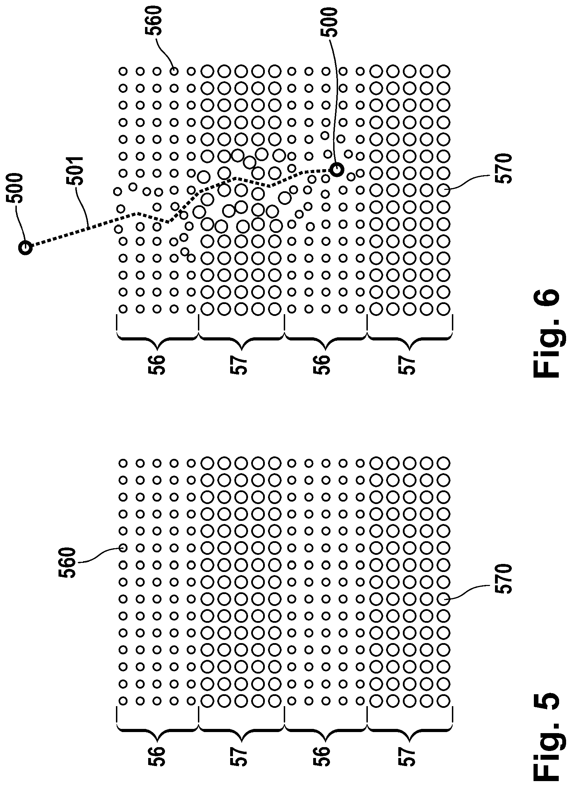

In Figur 5 ist die Struktur eines Viellagensystems vor einer Bestrahlung schematisch für zwei Spacerlagen 56 und zwei Absorberlagen 57 dargestellt. Im vorliegenden Beispiel handelt es sich ohne Beschränkung der Allgemeinheit beim Spacermaterial um Silizium, durch Siliziumatome 560 angedeutet, und beim Absorbermaterial um Molybdän, durch Molybdänatome 570 angedeutet. Im noch unbestrahlten Zustand weist die Anordnung der Siliziumatome 560 und der Molybdänatome 570 in ihren jeweiligen Lagen 56, 57 eine hohe Regelmäßigkeit auf, die sich in einer hohen Periodizität des Viellagensystems und einer hohen Reflektivität äußert.

In Figur 6 ist schematisch der Einfluss eines Galliumions 500 auf die Anordnung der Siliziumatome 560 und der Molybdänatome 570 in ihren jeweiligen Lagen 56, 57 angedeutet. Längs seiner Trajektorie 501 wird das Galliumion 500 an verschiedenen Atomen 560, 570 mehrfach inelastisch gestreut, bis das Galliumion 500 im Viellagensystem stecken bleibt. Die Eindringtiefe liegt je nach Energie des Galliumions zwischen einigen Nanometern bis wenigen 10 Nanometern. Die Atome 560, 570 längs der Trajektorie 501, an denen das Galliumion 500 inelastisch gestreut wurde, streuen ihrerseits inelastisch an benachbarten Atomen 560, 570, so dass die Ordnung der Atome 560, 570 verringert wird. Insbesondere werden die Grenzflächen zwischen einzelnen Lagen 56, 57 aufgerauht. Je nach Anzahl der Galliumionen kann die quadratische Rauheit im Bereich der mit Ionen bestrahlten Teilfläche bei über 0,25 nm oder über 0,35 nm oder sogar über 0,5 nm liegen.

Insbesondere bei Spiegeln oder für den Einsatz mit bereits recht homogener Bestrahlung oder bei Masken kann die Korrektur dazu führen, dass deren Reflektivität bei einer Wellenlänge höchster Reflektivität im Wellenlängenbereich von 5 nm bis 20 nm über die Fläche des Viellagensystems um nicht mehr als 1% um einen Mittelwert schwankt.

Zusätzlich zu der erhöhten Rauheit kann je nach Anzahl bzw. Konzentration der Ionen deren Präsenz den Realteil und den Imaginärteil des Brechungsindex der Spacer- bzw. der Absorberlage verändern, so dass der optische Kontrast zwischen Spacer- und Absorberlagen verringert werden kann, was ebenfalls zu einer reduzierten Reflektivität führt.

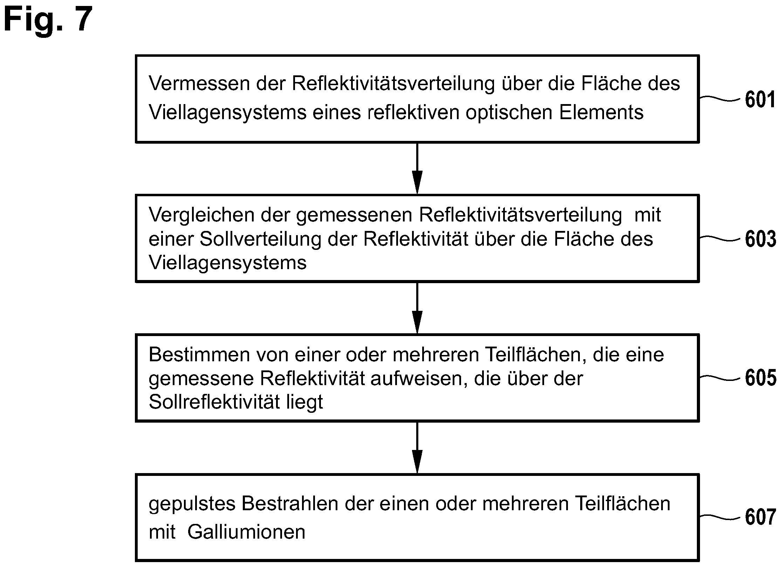

In Figur 7 ist exemplarisch der Ablauf einer Ausführungsform des hier vorgeschlagenen Korrekturverfahrens dargestellt. In einem ersten Schritt 601 wird die Reflektivitätsverteilung über die Fläche des Viellagensystems eines EUV-Spiegels, einer Maske oder eines Maskenrohlings vermessen. Bei diesen optischen Elementen handelt es sich jeweils um ein reflektives optisches Element für den Wellenlängenbereich von 5 nm bis 20 nm, das auf einem Substrat ein Viellagensystem wie zuvor erläutert aufweist, wobei das Viellagensystem Lagen aus mindestens zwei verschiedenen Materialien mit unterschiedlichem Realteil des Brechungsindex bei einer Wellenlänge im extrem ultravioletten Wellenlängenbereich aufweist, die abwechselnd angeordnet sind.

In einem zweiten Schritt 603 wird die gemessene Reflektivitätsverteilung mit einer Sollverteilung der Reflektivität über die Fläche des Viellagensystems verglichen. Je nach Anwendung und Art des EUV-Spiegels kann die Sollverteilung beispielsweise dafür optimiert sein, dass einfallende Strahlung mit einer über die Fläche des Viellagensystems inhomogenen Intensität derart reflektiert wird, dass die Intensitätsverteilung der reflektierten Strahlung über die Fläche homogener ist, oder dafür, das einfallende Strahlung mit homogener Intensitätsverteilung möglichst reflektiert wird, ohne dass sich die Homogenität der Intensitätsverteilung verschlechtert. In diesem Fall sollte die Sollverteilung um nicht mehr als 1 %, bevorzugt nicht mehr als 0,5%, besonders bevorzugt nicht mehr als um 0,1% um einen Mittelwert schwanken.

Anschließend werden in einem dritten Schritt 605 eine oder mehrere Teilflächen bestimmt, die eine gemessene Reflektivität aufweisen, die über der Sollreflektivität liegt. Diese eine oder mehreren Teilflächen werden in einem weiteren Schritt 607 gepulst mit Galliumionen bestrahlt. Außerdem mit Galliumionen können sie auch mit Indium-, Wismuth-, Zinn- oder Goldionen oder auch mit Elektronen gepulst bestrahlt werden. Durch das gepulste Bestrahlen kann die eingetragene Energiedosis besser kontrolliert werden. Insbesondere kann dadurch einfacher gewährleistet werden, dass der Energieeintrag ausreicht, um die Struktur im Viellagensystem auf atomarer Ebene zu verändern, aber keine chemischen Reaktionen gefördert werden, die zu einer Kontraktion oder Expansion des Viellagensystems führen würden und dadurch die optischen Eigenschaften des jeweiligen reflektiven optischen Elements verändern könnten.

Insbesondere sollte vorteilhafterweise beim Bestrahlen die Energie der Ionen oder ggf. Elektronen derart gewählt sein, dass sie unter der Sputtergrenze und unter der Kompaktierungsgrenze liegt. Ein Abtragen von Material des Viellagensystems könnte zu unerwünschten Änderungen von optischen Eigenschaften des EUV-Spiegels, der Maske oder des Maskenrohlings führen wie auch zu unkontrollierter Reduzierung der Reflektivität an der bestrahlten Stelle. Das gesputterte Material könnte auch zu unerwünschter Kontamination benachbarter Teilflächen auf der Oberfläche des jeweiligen reflektiven optischen Elements führen. Je nach Materialbeschaffenheit kann die Energie der Ionen oder Elektronen zusätzlich so gewählt werden, dass bei der Bestrahlung keine Kompaktierung der bestrahlten Lagen stattfindet, beispielsweise durch Verdichtung oder chemische Reaktionen, sondern nur die Schärfe der Grenzflächen zwischen den einzelnen Lagen beeinflusst wird. Eine Kompaktierung könnte die optischen Eigenschaften des Spiegels, das Maskenrohlings oder der Maske verändern.

Außerdem hat es sich besonders bewährt, wenn die eine oder mehreren Teilflächen zur Korrektur der Reflektivität mit einem fokussierten lonen- oder ggf. Elektronenstrahl bestrahlt werden. Dadurch können auch kleinere Teilflächen gezielt korrigiert werden. Kommerziell erhältliche Geräte, die fokussierte lonenstrahlen zur Verfügung stellen, bieten laterale Auflösungen bis 10 nm. Mit kommerziell erhältlichen Elektronenschreibern können Auflösungen bis hinab in den Subnanometerbereich erreicht werden. Somit kann die Reflektivität des jeweiligen reflektiven optischen Elements besonders präzise korrigiert werden. Eine besonders homogene Korrektur kann erhalten werden, wenn mit lateralen Auflösungen im Bereich von einigen 10 nm bis einigen Mikrometern gearbeitet wird. Die sehr stark fokussierten Strahlen kann man insbesondere nutzen, wenn Mikro- oder Nanostrukturen in die jeweilige Schicht eingebracht werden soll, die beispielsweise als diffraktive Elemente wirken können.

Bei Masken kann es zu lokalen Abweichungen der Breite der Maskenstrukturen von der jeweiligen Sollbreite kommen, was sich in lokalen Variationen der Masken-CD äußert und entsprechenden Abweichungen der Strukturen auf dem herzustellenden Halbleiterelement, etwa einen Chip führen kann. Für Masken zur Anwendung im DUV-Wellenlängenbereich ist bekannt, dass sich solche ungewollten Abweichungen der Maskenstruktur durch eine lokale Änderung der Transmission der Maske kompensieren lassen, indem beispielsweise streuende Pixel mittels eines Femtosekundenlasers eingeschrieben werden, wie etwa in der WO 2016/042549 A2 beschrieben. Die Erfinder haben nun erkannt, dass sich bei Masken für den EUV-Wellenlängenbereich entsprechende CD-Korrekturen durch lokale Änderung der lokalen Reflektivität wie hier beschrieben erreichen lassen und zumindest teilweise die Abweichung vom CD-Sollwert verringert werden kann.

Es sei darauf hingewiesen, dass die vorliegende Erfindung zwar anhand einer EUV-Lithographievorrichtung näher erläutert wurde, alle Ausführungen aber ebenso für andere Anwendungen wie etwa Masken- oder Waferinspektionsvorrichtungen mit Spiegeln oder optischen Systemen wie zuvor beschrieben gelten.

### Bezugszeichen

- 10: EUV-Lithographievorrichtung
- 11: Betriebsstrahl
- 12: EUV-Strahlungsquelle
- 13: Kollektorspiegel
- 14: Beleuchtungssystem
- 15: erster Spiegel
- 16: zweiter Spiegel
- 17: Maske
- 18: dritter Spiegel
- 19: vierter Spiegel
- 20: Projektionssystem
- 21: Wafer
- 50: Kollektorspiegel
- 51: Substrat
- 52: Polierschicht
- 53: Schutzlage
- 54: Viellagensystem
- 55: Lagenpaar
- 56: Spacer
- 57: Absorber
- 58: Maske
- 59: absorbierende Schicht
- 200: EUV-Spiegel
- 202: Fläche
- 204: Gebiet
- 206: Teilfläche
- 500: Galliumion
- 501: Trajektorie
- 560: Siliziumatom
- 570: Molybdänatom
- 601 bis 607: Verfahrensschritte

## Patentansprüche

1. Verfahren zur Korrektur eines reflektiven optischen Elements für den Wellenlängenbereich von 5 nm bis 20 nm, das auf einem Substrat ein Viellagensystem aufweist, wobei das Viellagensystem Lagen aus mindestens zwei verschiedenen Materialien mit unterschiedlichem Realteil des Brechungsindex bei einer Wellenlänge im extrem ultravioletten Wellenlängenbereich aufweist, die abwechselnd angeordnet sind, und wobei das reflektive optische Element eine oder mehrere Teilflächen aufweist, die eine gemessene Reflektivität aufweist bzw. aufweisen, die über einer Sollreflektivität einer Sollverteilung der Reflektivität über die Fläche des Viellagensstems liegt, wobei das Viellagensystem an dieser oder diesen Teilfläche(n) mit Elektronen bestrahlt wird, so dass lokal die Struktur des Viellagensystems verändert und die Reflektivität geringer wird.

2. Verfahren nach Anspruch 1, wobei die Sollverteilung um nicht mehr als 1% um einen Mittelwert schwankt.

3. Verfahren nach Anspruch 1 oder 2, wobei beim Bestrahlen die Energie der Elektronen derart gewählt ist, dass kein Material abgetragen wird und/ oder keine Kompaktierung erfolgt.

4. Verfahren nach einem der Ansprüche 1 bis 3, wobei mit einem gepulsten Elektronenstrahl bestrahlt wird.

5. EUV-Lithographievorrichtung oder Masken- oder Waferinspektionssystem mit einem optischen System mit einem reflektiven optischen Element korrigiert gemäß einem der Ansprüche 1 bis 4 und einer EUV-Strahlungsquelle, wobei die Strahlung der EUV-Strahlungsquelle mit einer über die Fläche des Viellagensystems des reflektiven optischen Elements variierenden Intensität auf das reflektive optische Element trifft, und wobei die eine oder mehreren mit Elektronen bestrahlten Teilflächen (206) in Flächenbereichen (204) höherer Intensität liegen.

6. EUV-Lithographievorrichtung oder Masken- oder Waferinspektionssystem gemäß Anspruch 5, wobei die eine oder mehreren Teilflächen (206), die in Flächenbereichen (204) höherer Intensität liegen, eine quadratische Rauheit von über 0,25 nm aufweisen.

## Claims

1. Method for correcting a reflective optical element for the wavelength range from 5 nm to 20 nm, having a multilayer system on a substrate, wherein the multilayer system has layers made from at least two different materials having a different real part of the refractive index at a wavelength in the extreme ultraviolet wavelength range, which are arranged alternately, and wherein the reflective optical element has one or more partial faces that has or have a measured reflectivity that lies above a target reflectivity of a target distribution of the reflectivity over the face of the multilayer system, wherein the multilayer system is irradiated with electrons on this or these partial face(s), such that the structure of the multilayer system is locally modified and the reflectivity becomes lower.

2. Method according to Claim 1, wherein the target distribution fluctuates around an average by no more than 1%.

3. Method according to Claim 1 or 2, wherein the energy of the electrons during irradiation is selected such that no material is removed and/or no compaction takes place.

4. Method according to one of Claims 1 to 3, wherein a pulsed electron beam is used for the irradiation.

5. EUV lithography apparatus or mask or wafer inspection system having an optical system having a reflective optical element corrected according to one of Claims 1 to 4 and an EUV radiation source, wherein the radiation of the EUV radiation source is incident on the reflective optical element with an intensity that varies over the face of the multilayer system of the reflective optical element, and wherein the one or more partial faces (206) irradiated with electrons lie in face regions (204) of a higher intensity.

6. EUV lithography apparatus or mask or wafer inspection system according to Claim 5, wherein the one or more partial faces (206) that lie in face regions (204) of a higher intensity have a root-mean-squared roughness of over 0.25 nm.

## Revendications

1. Procédé de correction d'un élément optique réfléchissant pour la gamme de longueurs d'onde allant de 5 nm à 20 nm qui présente un système multicouche sur un substrat, dans lequel le système multicouche présente des couches composées d'au moins deux matériaux différents ayant une composante réelle différente de l'indice de réfraction à une longueur d'onde dans la gamme des longueurs d'onde ultraviolettes extrêmes, qui sont disposées en alternance, et dans lequel l'élément optique réfléchissant présente une ou plusieurs surfaces partielles qui présente(nt) une réflectivité mesurée qui est supérieure à une réflectivité de consigne d'une distribution de consigne de la réflectivité sur la surface du système multicouche, dans lequel le système multicouche est irradié au niveau de cette surface partielle ou de ces surfaces partielles par des électrons de sorte que la structure du système multicouche est modifiée et la réflectivité diminue localement.

2. Procédé selon la revendication 1, dans lequel la distribution de consigne ne varie pas de plus de 1 % autour d'une valeur moyenne.

3. Procédé selon la revendication 1 ou 2, dans lequel lors de l'irradiation, l'énergie des électrons est choisie de telle sorte qu'aucune matière ne soit enlevée et/ou aucune compression n'ait lieu.

4. Procédé selon l'une quelconque des revendications 1 à 3, dans lequel l'irradiation est effectuée à l'aide d'un faisceau d'électrons pulsé.

5. Dispositif de lithographie EUV ou système d'inspection de masques ou de tranches, comprenant un système optique corrigé par un élément optique réfléchissant selon l'une quelconque des revendications 1 à 4 et une source de rayonnement EUV, dans lequel le rayonnement de la source de rayonnement EUV atteint l'élément optique réfléchissant avec une intensité variable sur la surface du système multicouche de l'élément optique réfléchissant, et dans lequel ladite une ou les plusieurs surfaces partielles (206) irradiées par des électrons se trouvent dans des zones de surface (204) à intensité supérieure.

6. Dispositif de lithographie EUV ou système d'inspection de masques ou de tranches selon la revendication 5, dans lequel ladite une ou les plusieurs surfaces partielles (206) qui se trouvent dans des zones de surface (204) à intensité supérieure présentent une rugosité quadratique de plus de 0,25 nm.
